(19) Europäisches Patentamt
European Patent Office
Office européen des brevets

(11) **EP 3 735 741 B1**

(12) **EUROPÄISCHE PATENTSCHRIFT**

(45) Veröffentlichungstag und Bekanntmachung des Hinweises auf die Patenterteilung:
**13.11.2024 Patentblatt 2024/46**

(21) Anmeldenummer: **18825652.3**

(22) Anmeldetag: **17.12.2018**

(51) Internationale Patentklassifikation (IPC):
*H02P 27/08* (2006.01)  *G01R 19/00* (2006.01)
*H02M 7/5395* (2006.01)  *H02M 1/00* (2006.01)
*H02M 7/5387* (2007.01)

(52) Gemeinsame Patentklassifikation (CPC):
**H02P 27/08; H02M 7/53878; H02M 7/5395;**
G01R 19/0092; H02M 1/0009

(86) Internationale Anmeldenummer:
**PCT/EP2018/085261**

(87) Internationale Veröffentlichungsnummer:
**WO 2019/134816 (11.07.2019 Gazette 2019/28)**

(54) **VERFAHREN UND VORRICHTUNG ZUM BETREIBEN EINER ELEKTRISCHEN SYNCHRONMASCHINE MIT 1-SHUNT-STROMMESSUNG**

METHOD AND APPARATUS FOR OPERATING AN ELECTRIC SYNCHRONOUS MACHINE WITH 1-SHUNT CURRENT MEASUREMENT

PROCÉDÉ ET DISPOSITIF POUR FAIRE FONCTIONNER UNE MACHINE ÉLECTRIQUE SYNCHRONE AVEC MESURE DE COURANT À 1 SHUNT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.01.2018 DE 102018200085**

(43) Veröffentlichungstag der Anmeldung:
**11.11.2020 Patentblatt 2020/46**

(73) Patentinhaber: **Robert Bosch GmbH**
**70442 Stuttgart (DE)**

(72) Erfinder:
• **JERGER, Armin**
**76547 Sinzheim (DE)**
• **BECKER, Markus**
**77728 Oppenau (DE)**
• **VOLLMER, Ulrich**
**73235 Weilheim (DE)**

(56) Entgegenhaltungen:
**DE-A1- 102005 062 759     DE-A1- 102011 003 897**
**DE-A1- 102015 202 693**

**Beschreibung**

Die Erfindung betrifft ein Verfahren zum Betreiben einer elektrischen Synchronmaschine. Die Erfindung betrifft weiterhin eine Vorrichtung zum Betreiben einer elektrischen Synchronmaschine. Die Erfindung betrifft weiterhin ein Computerprogrammprodukt und ein computerlesbares Speichermedium.

Stand der Technik

Bekannt sind Anwendungen von permanenterregten Synchronmaschinen als Antrieb für Lüfter, zum Beispiel Kühlerlüfter im Kraftfahrzeugbereich. Bekannt ist ferner eine sensorlose Regelung von Synchronmaschinen, das heißt eine Regelung ohne Verwendung eines Rotorlage-Sensors. Die Rotorlage wird dann aus der induzierten elektrischen Spannung (BEMF, back electromotive force, elektromotorische Kraft EMK) der Synchronmaschine bestimmt.

Für die Ansteuerung bzw. Regelung von elektrischen Synchronmaschinen ist in vielen Fällen die Kenntnis der elektrischen Phasenströme der Synchronmaschinen erforderlich. Die elektrischen Phasenströme werden beispielsweise als Eingangsgröße für Verfahren zur sensorlosen Rotorwinkelschätzung oder für Regelungsverfahren benötigt.

In einer kostenoptimierten Lösung werden die elektrischen Phasenströme über lediglich einen Shunt im gemeinsamen Masse- bzw. Versorgungspfad von Halbbrücken ("1-Shunt-Strommessung") bestimmt.

Die DE 10 2015 202 693 A1 offenbart ein Verfahren zur Strangstrombestimmung in einem elektrischen Mehrphasensystem.

Die DE 10 2011 003 897 A1, von der die Erfindung ausgeht, und die DE 10 2205 062 759 offenbaren jeweils ein Verfahren und eine Vorrichtung zur Strommessung.

Offenbarung der Erfindung

Es ist eine Aufgabe der vorliegenden Erfindung, ein Verfahren zum verbesserten Betreiben einer Synchronmaschine bereitzustellen.

Die Aufgabe wird gemäß einem ersten Aspekt gelöst mit einem Verfahren zum Betreiben einer elektrischen Synchronmaschine, aufweisend die Schritte:

- Generieren von mittenzentrierten pulsweitenmodulierten Schaltsignalen für Schaltelemente von Halbbrücken, wobei jeweils zwei der Schaltelemente zu jeweils einer Halbbrücke verschaltet sind, wobei zweite Schaltelemente jeder Halbbrücke komplementär zu ersten Schaltelementen jeder Halbbrücke angesteuert werden, sofern dadurch eine ausreichende Mindestmessdauer bereitgestellt wird, während der die Schaltsignale von Schaltelementen zweier Halbbrücken auf unterschiedlichen Potentialen liegen;
- Andernfalls:
- Generieren von pulsweitenmodulierten Schaltsignalen für die Schaltelemente der Halbbrücken, die mindestens so weit von der Mittenzentrierung abweichen, dass eine ausreichende Mindestmessdauer bereitgestellt wird, wobei die Schaltsignale der Schaltelemente derart ausgebildet werden, dass zeitliche Sprünge entsprechend der Mindestmessdauer in den Schaltsignalen der Schaltelemente vermieden werden,
- Durchführen einer 1-Shunt-Strommessung innerhalb der bereitgestellten Mindestmessdauer ($T_M$), wobei im Falle dass wenigstens zwei Schaltsignale der ersten Schaltelemente (T1, T3, T5) ein definiert großes unterschiedliches Tastverhältnis aufweisen, im Falle einer Änderung von Größenverhältnissen der Schaltsignale bei einem Übergang von einem Schaltzyklus zum nächsten, die Schaltsignale derart ausgebildet werden, dass die 1-Shunt-Strommessungen jeweils bei wechselnden Flanken der Schaltsignale durchgeführt werden.

Auf diese Weise kann ein geräuschoptimierter Betrieb der sensorlos geregelten Synchronmaschine mit spezifisch nicht-mittenzentrierten Ansteuersignalen erreicht werden, weil zeitliche Sprünge um die Messdauer in den Phasensignalen vermieden werden.

Vorzugsweise wird im Betrieb der Synchronmaschine ein Szenario abgedeckt, bei welchem aufgrund von hohen Unterschieden in den Tastverhältnissen der Ansteuersignale hohe elektrische Motorspannungen auftreten. Auch in diesem Fall kann insbesondere ein sehr geräuschloser Betrieb der Synchronmaschine unterstützt sein.

Die Aufgabe wird gemäß einem zweiten Aspekt gelöst mit einer Vorrichtung zum Betreiben einer elektrischen Synchronmaschine, aufweisend:

- eine Generierungseinrichtung zum Generieren von mittenzentrierten pulsweitenmodulierten Schaltsignalen für Schaltelemente von Halbbrücken, wobei jeweils zwei der Schaltelemente zu jeweils einer Halbbrücke verschaltet sind, wobei zweite Schaltelemente jeder Halbbrücke komplementär zu ersten Schaltelementen jeder Halbbrücke angesteuert werden, sofern dadurch eine ausreichende Mindestmessdauer bereitgestellt wird, während der die Schaltsignale von Schaltelementen zweier Halbbrücken auf unterschiedlichen Potentialen liegen,
- Andernfalls: zum Generieren von pulsweitenmodulierten Schaltsignalen für die Schaltelemente der Halbbrücken, die mindestens so weit von der Mittenzentrierung abweichen, dass eine ausreichende Mindestmessdauer bereitgestellt wird;
- wobei mittels der Generierungseinrichtung die Schaltsignale der Schaltelemente derart ausbildbar sind, dass zeitliche Sprünge in den Schaltsignalen der Schaltelemente entsprechend der Mindestmessdauer vermieden werden,

- eine Messeinrichtung (220) zum Durchführen einer 1-Shunt- Strommessung, wobei mittels der Schaltsignale der Schaltelemente (T1 ...T6) eine definierte Mindestmessdauer ($T_M$) bereitgestellt wird, während der zwei Schaltsignalsignale einer Halbbrücke auf unterschiedlichen Potentialen liegen,

wobei im Falle, dass wenigstens zwei Schaltsignale der ersten Schaltelemente (T1, T3, T5) ein definiert großes unterschiedliches Tastverhältnis aufweisen, im Falle einer Änderung von Größenverhältnissen der Schaltsignale bei einem Übergang von einem Schaltzyklus zum nächsten, die Schaltsignale derart ausgebildet werden, dass die 1-Shunt-Strommessungen jeweils bei wechselnden Flanken der Schaltsignale durchgeführt werden.

Bevorzugte Ausführungsformen des Verfahrens zum Betreiben einer elektrischen Synchronmaschine sind Gegenstand von abhängigen Ansprüchen.

Eine bevorzugte Weiterbildung des Verfahrens sieht vor, dass im Falle, dass bei der 1-Shunt-Strommessung an den positiven Schaltflanken zwei Schaltsignale von unterschiedlichen Schaltelementen ein ähnliches Tastverhältnis aufweisen, die Schaltsignale der Schaltelemente mit dem größeren Tastverhältnis nach links, und das Schaltsignal des Schaltelements mit dem kleineren Tastverhältnis nach rechts verschoben werden.

Eine weitere bevorzugte Weiterbildung des Verfahrens ist dadurch gekennzeichnet, dass im Falle, dass bei der 1-Shunt-Strommessung an den negativen Schaltflanken zwei Schaltsignale von unterschiedlichen Schaltelementen ein ähnliches Tastverhältnis aufweisen, die Schaltsignale der Schaltelemente mit dem größeren Tastverhältnis nach rechts, und das Schaltsignal des Schaltelements mit dem kleineren Tastverhältnis nach links verschoben werden.

Eine bevorzugte Weiterbildung des Verfahrens sieht vor, dass im Falle, dass die Schaltsignale der ersten Schaltelemente ein definiert ähnliches Tastverhältnis aufweisen, steigende Flanken der drei Schaltsignale der ersten Schaltelemente, bei denen die 1-Shunt-Strommessung durchgeführt wird, in ihrer zeitlichen Abfolge relativ zueinander fest sind und derart ausgebildet werden, dass die Mindestmessdauer zwischen den Schaltsignalen der ersten Schaltelemente bereitgestellt wird, wobei die 1-Shunt-Strommessung bei steigenden Flanken der Schaltsignale der ersten Schaltelemente in der ersten Hälfte der PWM-Periode durchgeführt werden. Auf diese Weise wird ein Szenario im Betrieb der Synchronmaschine berücksichtigt, welches aufgrund von geringen Unterschieden in den Tastverhältnissen eine geringe Motorleistung bzw. -drehzahl realisiert.

Eine weitere bevorzugte Weiterbildung des Verfahrens ist dadurch gekennzeichnet, dass im Falle, dass die Schaltsignale der ersten Schaltelemente ein definiert ähnliches Tastverhältnis aufweisen, fallende Flanken der drei Schaltsignale der ersten Schaltelemente, bei denen die 1-Shunt-Strommessung durchgeführt wird, in ihrer zeitlichen Abfolge relativ zueinander fest sind und derart ausgebildet werden, dass die Mindestmessdauer zwischen den Schaltsignalen der ersten Schaltelemente bereitgestellt wird, wobei die 1-Shunt-Strommessung bei fallenden Flanken der Schaltsignale der ersten Schaltelemente in der zweiten Hälfte der PWM-Periode durchgeführt werden. Auf diese Weise wird für die Synchronmaschine ein ähnliches Szenario wie zuvor beschrieben bereitgestellt, wobei in diesem Fall die 1-Shunt-Strommessung bei fallenden Flanken der Schaltsignale durchgeführt wird.

Eine weitere bevorzugte Ausführungsform des Verfahrens zeichnet sich dadurch aus, dass die Tastverhältnisse der drei Schaltsignale der Schaltelemente ähnlich und der Unterschied in den Tastverhältnissen der drei Schaltsignale vorzugsweise kleiner ca. 20% bis ca. 30% ist. Auf diese Weise wird das Verfahren für eine Vielzahl von unterschiedlichen Ausbildungen der Schaltsignale anwendbar. Vorzugsweise sind dadurch die Unterschiede in den Tastverhältnissen der drei Schaltsignale gering (d.h. bis ca. 20-30% Unterschiede in den Tastverhältnissen) bzw. die elektrische Motorspannungsamplitude ("Gesamttastverhältnis") max. ca. 20-30%. Vorteilhaft ist dabei ein Absolutwert der Tastverhältnisse der drei Schaltsignale irrelevant, z.B. könnten die drei Tastverhältnisse 60% oder 70% oder 80% betragen, das Verfahren würde vorteilhaft auch in diesen Fällen funktionieren, da der maximale Unterschied der Tastverhältnisse nur 20% wäre.

Eine weitere bevorzugte Ausführungsform des Verfahrens zeichnet sich dadurch aus, dass im Falle, dass wenigstens zwei Schaltsignale der ersten Schaltelemente ein definiert großes unterschiedliches Tastverhältnis aufweisen, der Unterschied im Tastverhältnis größer als ca. 25 % bis ca. 100% beträgt. Eine weitere bevorzugte Ausführungsform des Verfahrens sieht vor, dass das Verfahren für eine permanenterregte oder für eine fremderregte Synchronmaschine durchgeführt wird. Auf diese Weise kann das Verfahren vorteilhaft für bautechnisch unterschiedliche Synchronmaschinen verwendet werden.

Die Erfindung wird im Folgenden mit weiteren Merkmalen und Vorteilen anhand von mehreren Figuren im Detail beschrieben. Gleiche oder funktionsgleiche Elemente haben darin gleiche Bezugszeichen. Die Figuren sind insbesondere dazu gedacht, die erfindungswesentlichen Prinzipien zu verdeutlichen.

Offenbarte Vorrichtungsmerkmale ergeben sich analog aus entsprechenden offenbarten Verfahrensmerkmalen und umgekehrt. Dies bedeutet insbesondere, dass sich Merkmale, technische Vorteile und Ausführungen betreffend das Verfahren zum Betreiben einer elektrischen Synchronmaschine aus entsprechenden Ausführungen, Merkmalen und technischen Vorteilen betreffend die Vorrichtung zum Betreiben einer elektrischen Synchronmaschine ergeben und umgekehrt.

Ferner betrifft die Erfindung ein Computerprogrammprodukt, umfassend Befehle, die bewirken, dass die erfindungsgemäße Vorrichtung zum Betreiben einer elektrischen Synchronmaschine das erfindungsgemäße Verfahren ausführt.

Weiterhin betrifft die Erfindung ein computerlesbares Speichermedium, auf dem das erfindungsgemäße Computerprogrammprodukt gespeichert ist.

In den Figuren zeigt:

| | |
|---|---|
| Fig. 1 und 2 | prinzipielle Darstellungen zum Erläutern einer Wirkungsweise einer konventionellen 1-Shunt-Strommessung einer elektrischen Synchronmaschine; |
| Fig. 3 - 5 | prinzipielle Signaldiagramme zum Erläutern einer Wirkungsweise eines Betreibens einer elektrischen Synchronmaschine; |
| Fig. 6 | eine Darstellung zum Erläutern von Sektorwechsel beim Betreiben einer elektrischen Synchronmaschine; |
| Fig. 7 - 8 | Zeitdiagramme mit Ansteuersignalen gemäß einem konventionellen Verfahren zum Betreiben einer elektrischen Synchronmaschine; |
| Fig. 9 - 10 | eine prinzipielle Darstellung einer ersten Ausführungsform eines Verfahrens zum Betreiben einer elektrischen Synchronmaschine; |
| Fig. 11 - 12 | eine prinzipielle Darstellung einer weiteren Ausführungsform eines Verfahrens zum Betreiben einer elektrischen Synchronmaschine; |
| Fig. 13 | ein Ablaufdiagramm eines vorgeschlagenen Verfahrens zum Betreiben einer elektrischen Synchronmaschine; und |
| Fig. 14 | ein prinzipielles Blockschaltbild einer vorgeschlagenen Vorrichtung zum Betreiben einer elektrischen Synchronmaschine. |

Beschreibung von Ausführungsformen

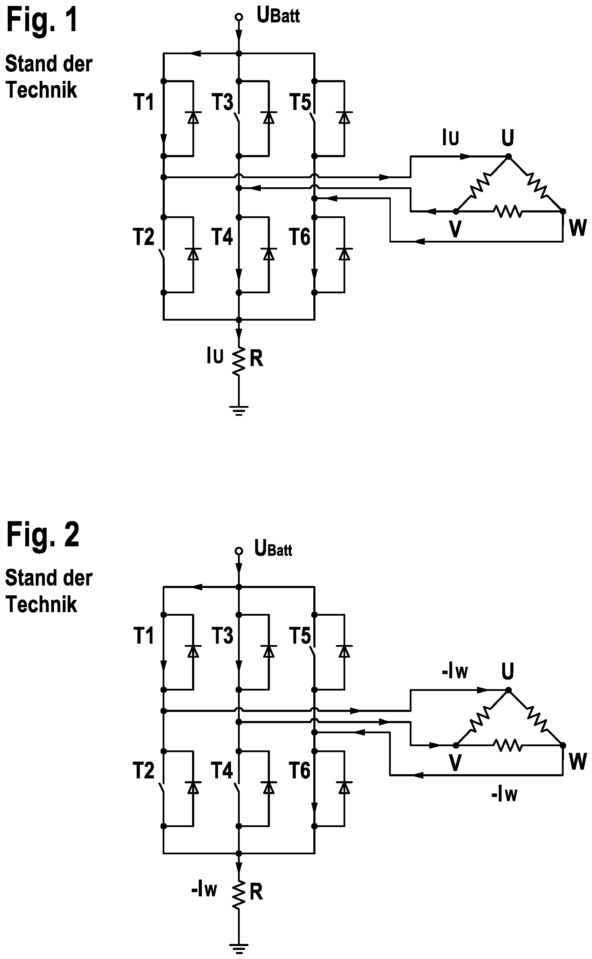

Fig. 1 zeigt ein prinzipielles Schaltbild einer konventionellen Vorrichtung zum Betreiben einer elektrischen Synchronmaschine, wobei die Synchronmaschine mittels pulsweitenmodulierten elektrischen Steuersignalen angesteuert wird. Die Vorrichtung umfasst vorzugsweise drei Halbbrücken mit Schaltelementen T1...T6, die die genannten Steuersignale für Phasenwicklungen der Synchronmaschine generieren.

Exemplarisch ist dies im Folgenden für ein 3-Phasensystem mit den drei Phasenanschlüssen U, V, W und einer B6-Brückenkonfiguration mit drei Halbbrücken T1-T2, T3-T4, T5-T6 bzw. einem Shunt R im Massepfad der Halbbrücken dargestellt.

Um vom elektrischen Shuntstrom $I_R$ auf die drei Phasenströme schließen zu können, müssen die sechs elektronischen Schaltelemente T1...T6 der B6-Brücke ein definiertes Schaltmuster aufweisen. Beispielsweise entspricht im Schaltmuster 1 von Fig. 1 der elektrische Shuntstrom $I_R$ dem Phasenstrom U. Im Schaltmuster 2 von Fig. 2 entspricht der elektrische Shuntstrom $I_R$ dem negativen elektrischen Phasenstrom W.

Die Generierung der drei elektrischen Phasenspannungen U, V und W erfolgt typischerweise mittels Pulsweitenmodulation (PWM), wobei zu diesem Zweck vorzugsweise, aber nicht ausschließlich mittenzentrierte PWM-Ansteuersignale verwendet werden.

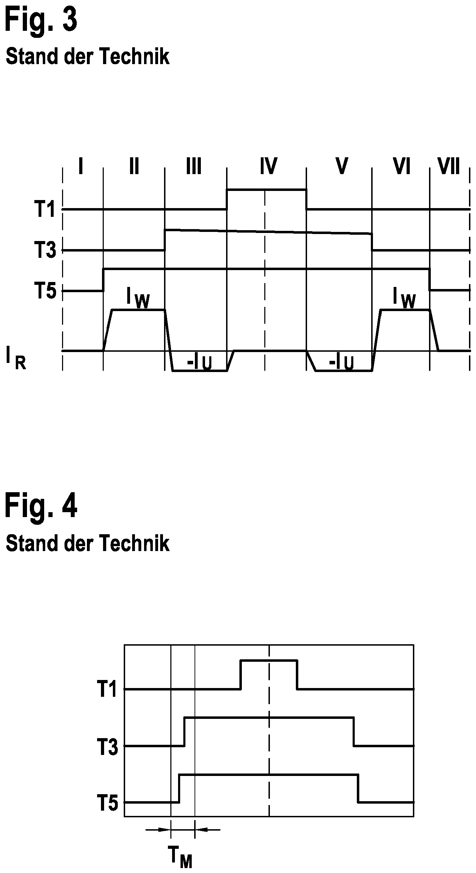

Fig. 3 zeigt ein Beispiel für ein Schaltmuster der drei High-Side-Schalter T1, T3, T5 während einer PWM-Periode mit mittenzentrierter PWM-Generierung sowie dem resultierenden elektrischen Shuntstrom $I_R$. Um die drei elektrischen Phasenströme während einer PWM-Periode bestimmen zu können, muss der elektrische Shuntstrom $I_R$ in zwei unterschiedlichen Schalterstellungen (einer der drei High-Side-Schalter geschlossen bzw. zwei der drei High-Side-Schalter geschlossen) erfasst werden. Im Beispiel von Fig. 3 wäre dies in den Zonen II und III bzw. in den Zonen V und VI möglich. Hierdurch können zwei der drei elektrischen Phasenströme über eine Messung des Shuntstroms $I_R$ direkt bestimmt werden, wobei dann der dritte elektrische Phasenstrom mittels der elektrischen Knotenregel berechnet werden kann.

Zur messtechnischen Erfassung des elektrischen Shuntstroms $I_R$ müssen die beiden Schaltmuster (einer der drei High-Side-Schalter T1, T3, T5 geschlossen bzw. zwei der drei High-Side-Schalter T1, T3, T5 geschlossen) für eine Mindestdauer anliegen. Falls die Tastverhältnisse an mindestens zwei der drei Phasen ähnlich sind, ist daher eine 1-Shunt-Strommessung ohne weitere Maßnahme nicht möglich. Im folgenden Beispiel wäre eine 1-Shunt-Strommessung nicht möglich, da die Tastverhältnisse an den Schaltelementen T3 und T5 zu ähnlich sind, wie es in Fig. 4 erkennbar ist.

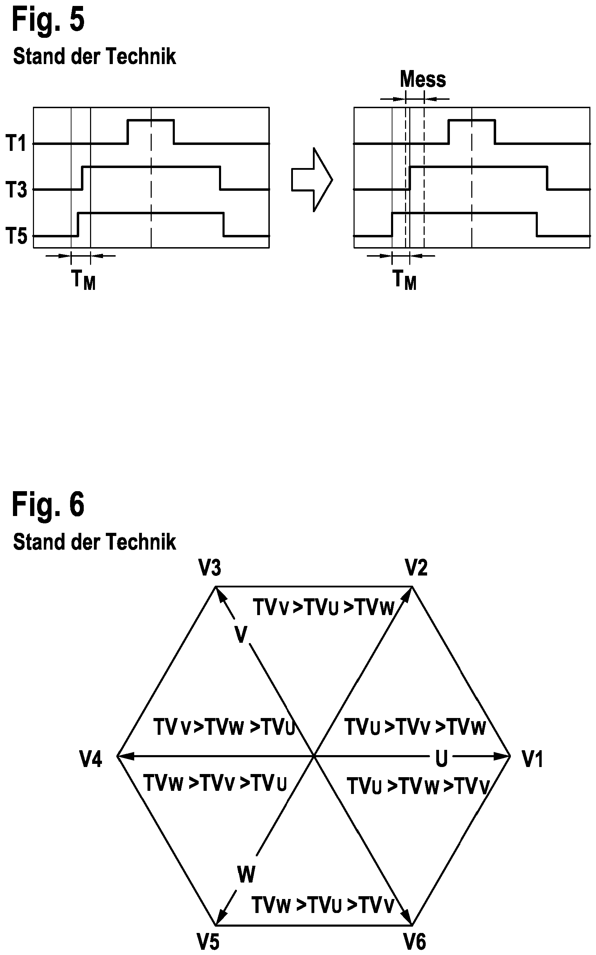

Um auch in solchen Fällen eine 1-Shunt-Strommessung zu ermöglichen, müssen die zwei Schaltflanken an mindestens einer der drei Halbbrücken T1-T2, T3-T4, T5-T6 zeitlich verschoben werden. Im folgenden Beispiel ist eine Bestimmung der Phasenströme mittels 1-Shunt-Strommessung nach Verschiebung der Schaltflanken an den Schaltelementen T3, T5 möglich, wie es in Fig. 5 erkennbar ist.

In welche Richtung die Flanken der PWM-Schaltsignale verschoben werden, wird typischerweise auf Basis des Größenverhältnisses der Tastverhältnisse an den drei Phasen bestimmt. Fig. 6 zeigt das Größenverhältnis der Tastverhältnisse an den drei Phasen U, V, W anhand eines Vektordiagramms. Bei einem sogenannten "Sektorwechsel" wird typischerweise auch die Richtung, in die die Schaltsignale verschoben werden, geändert. Dadurch erfolgt beim Sektorwechsel aber ein Sprung in der Position der Schaltflanken in der Länge der Mindestmessdauer $T_M$ und als Folge davon ein oftmals unerwünschter Sprung in den elektrischen Phasenstromverläufen. Diese Sprünge in den elektrischen Phasenströmen können, je nach Anwendung, kritisch betreffend ein Geräuschverhalten der Anwendung mit der elektrischen Synchronmaschine sein.

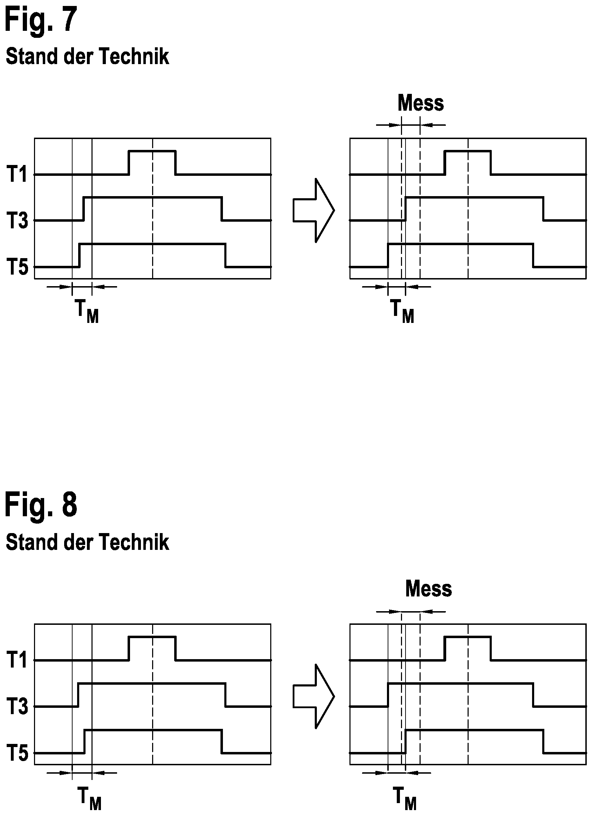

Das folgende Beispiel von Fig. 7 zeigt die resultierenden Schaltmuster vor und nach einem Sektorwechsel, wobei vor dem Sektorwechsel die Bedingung:

$$TV_W > TV_V > TV_U$$

mit:

$TV_W$    Tastverhältnis W

$TV_V$    Tastverhältnis V

$TV_U$    Tastverhältnis U

gilt und nach dem Sektorwechsel die Bedingung:

$$TV_V > TV_W > TV_U$$

Aufgrund der auf diese Weise generierten Sprünge der Schaltsignale um jeweils eine Mindestmessdauer $T_M$ wird ein wechselnder Phasenstrom generiert mit einem davon verursachten unerwünschten Geräuschpegel.

Vorgeschlagen wird daher, die Phasen der Schaltsignale derart anzuordnen, dass die genannten Sprünge nicht mehr auftreten.

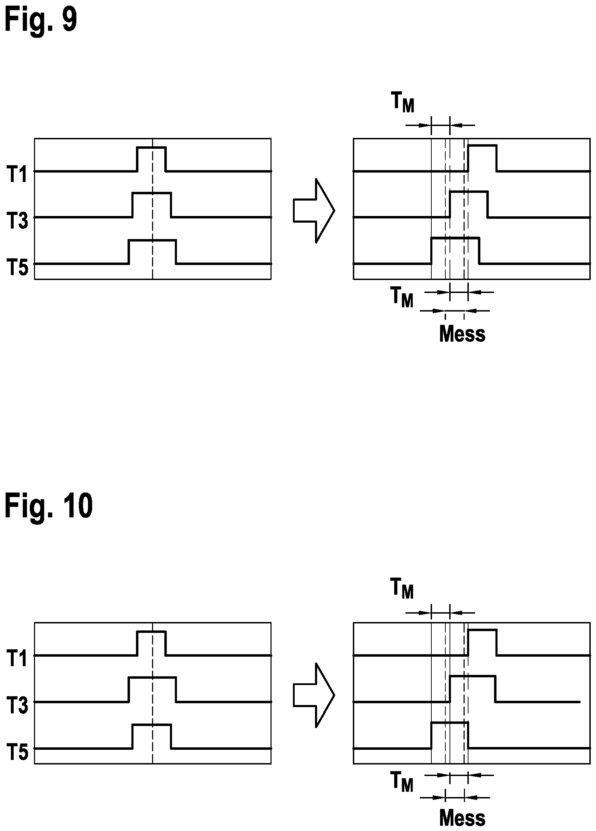

Fig. 9 zeigt in der rechten Darstellung eine erste Ausführungsform des vorgeschlagenen Verfahrens, die linke Darstellung repräsentiert die Schaltsignale ohne erfindungsgemäße Abwandlung. Man erkennt, dass die Tastverhältnisse der drei Schaltsignale ähnlich sind, wobei der Unterschied in den Tastverhältnissen der drei Schaltsignale vorzugsweise kleiner ca. 20% bis ca. 30% ist. In diesem Fall werden bei einem Sektorwechsel die steigenden Flanken der drei Schaltsignale fest positioniert, sodass die Mindestmessdauer $T_M$ zum Durchführen der 1-Shunt-Strommessung bereitgestellt ist.

Dies ist auch in der rechten Darstellung von Fig. 10 der Fall, in der sich die Flanken innerhalb der einzelnen Schaltsignale nur unwesentlich verändern und dadurch im Ergebnis ein geräuschmäßig ruhiger Lauf der Synchronmaschine zustande kommt. Im Ergebnis sind dadurch die drei Schaltsignale in den rechten Darstellungen der Figuren 9 und 10 nicht mehr mittenzentriert.

Von Fig. 9 auf Fig. 10 wird derselbe Sektorwechsel realisiert wie im konventionellen Verfahren von Fig. 7 auf Fig. 8.

Nicht in den Figuren dargestellt ist der Fall, dass die genannte Fixierung der Schaltsignale auf die fallenden Flanken der Signale bezogen ist, sodass auch in diesem Fall innerhalb der einzelnen PWM-Schaltsignale keine bedeutenden, geräuschverursachenden Sprünge auftreten.

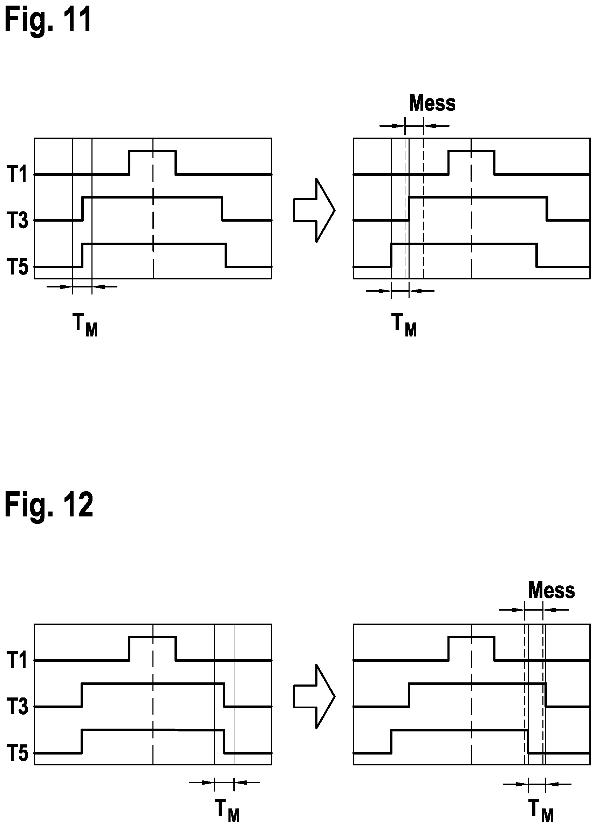

Fig. 11 und Fig. 12 zeigt eine weitere Ausführungsform des vorgeschlagenen Verfahrens, wobei in diesem Fall zwischen den Tastverhältnissen wenigstens zweier PWM-Schaltsignale eine große Differenz besteht, sodass das Verfahren von Fig. 9 und Fig. 10 nicht anwendbar wäre. In diesem Fall werden beim Sektorwechsel, d.h. beim Übergang von Fig. 11 auf Fig. 12 die PWM-Schaltsignale derart ausgebildet bzw. angeordnet, dass die Messung einmal abwechselnd bei den steigenden Flanken (rechte Darstellung von Fig. 11) oder nach dem Sektorwechsel bei den fallenden Flanken (rechte Darstellung von Fig. 12) durchgeführt wird. Auch in diesem Fall ist erkennbar, dass die Schaltsignale gemäß der rechten Darstellungen keine wesentlichen Sprünge aufweisen und dadurch ein ruhiger Phasenstromverlauf generiert ist.

Im Ergebnis sind dadurch auch in dieser Variante die drei Schaltsignale in den rechten Darstellungen der Figuren 11 und 12 definiert abweichend von der Mittenzentriertheit.

Im Ergebnis entspricht dies einer Ausführung, die insbesondere bei mittleren und hohen elektrischen Motorspannungsamplituden zur Anwendung kommt, wobei zwar die Position der Schaltflanken entsprechend dem Größenverhältnis der Tastverhältnisse an den drei Halbbrücken verschoben wird, falls mit den ursprünglichen (unveränderten) Schaltmustern keine 1-Shunt-Strommessung möglich wäre.

Dabei wird bei jedem Sektorwechsel eine Messung des Shuntstroms $I_R$ an den positiven Schaltflanken bzw. an den negativen Schaltflanken durchgeführt. Durch diese Vorgehensweise bleibt die Position der Schaltflanken während des Sektorwechsels unverändert, wodurch Sprünge in den Schaltflanken und damit in den Phasenstromverläufen vorteilhaft vermieden werden.

Weisen, bei Messung des elektrischen Shuntstroms $I_R$ an den positiven Schaltflanken zwei Schaltsignale von unterschiedlichen Phasen ein ähnliches Tastverhältnis auf, so werden die Schaltsignale an der Phase mit dem größeren Tastverhältnis nach links, an der Phase mit dem kleineren Tastverhälntnis nach rechts verschoben. Weisen, bei Messung des elektrischen Shuntstroms $I_R$ an den negativen Schaltflanken zwei Phasen ein ähnliches Tastverhältnis auf, so werden die Schaltsignale an der Phase mit dem größeren Tastverhältnis nach rechts, an der Phase mit dem kleineren Tastverhältnis nach links verschoben.

Im folgenden Beispiel gemäß Fig. 12 wird beim Sektorwechsel:

$$TV_W > TV_V > TV_U$$

von einer Messung des Phasenstrom an den positiven Schaltflanken zu einer Messung des Phasenstroms an den negativen Schaltflanken gewechselt. Die Position der Schaltflanken bleibt dabei unverändert.

Vorteilhaft erfordert das vorgeschlagene Verfahren keinerlei zusätzliche Hardware, sondern kann ausschließlich per Software implementiert werden, wobei geeignete Algorithmen programmiertechnisch in einem Mikrocontroller hinterlegt werden. Dadurch ist eine einfache Adaptier- bzw. Änderbarkeit des Verfahrens unterstützt.

Vorteilhaft lässt sich das vorgeschlagene Verfahren sowohl bei permanent- als auch bei fremderregten Synchronmaschinen realisieren.

Vorgehend wurde das vorgeschlagene Verfahren beispielhaft an Hand einer dreiphasigen Synchronmaschine beschrieben, wobei jedoch darauf hingewiesen wird, dass das vorgeschlagene Verfahren auch für ein-, zwei-, vier-, fünf- und mehrphasige Synchronmaschinen verwendet werden kann.

Vorgehend wurde das vorgeschlagene Verfahren beispielhaft an Hand der High-Side-Schalter T1, T3, T5 beschrieben. Es versteht sich jedoch von selbst, dass eine Ausführung des Verfahrens auch mittels der Low-Side-Schalter T2, T4, T6 möglich ist.

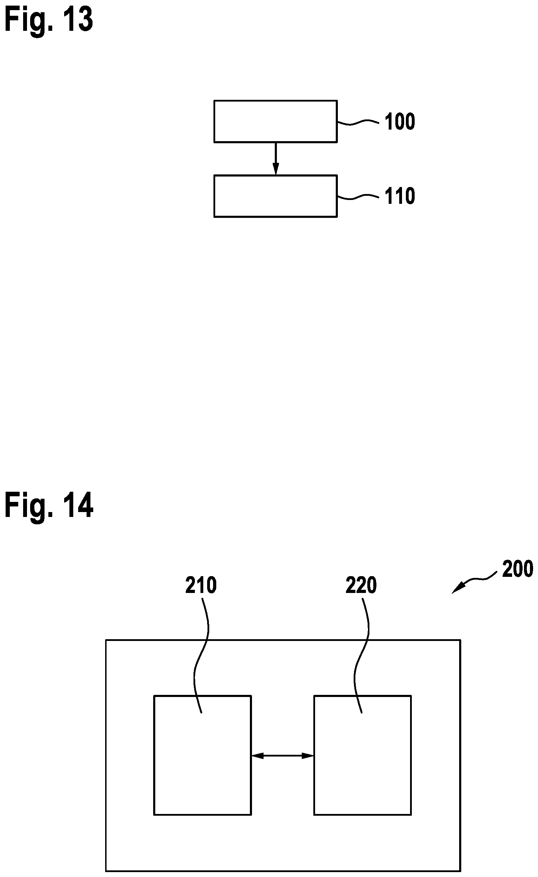

Fig. 13 zeigt einen prinzipiellen Ablauf eines vorgeschlagenen Verfahrens zum Betreiben einer elektrischen Synchronmaschine.

In einem Schritt 100 wird ein Generieren von mittenzentrierten pulsweitenmodulierten Schaltsignalen für Schaltelemente T1...T6 von Halbbrücken durchgeführt, wobei jeweils zwei der Schaltelemente T1 ... T6 zu jeweils einer Halbbrücke verschaltet sind, wobei zweite Schaltelemente T4 ... T6 jeder Halbbrücke komplementär zu ersten Schaltelementen T1 ... T3 jeder Halbbrücke angesteuert werden, sofern dadurch eine ausreichende Mindestmessdauer $T_M$ bereitgestellt wird, während der die Schaltsignale von Schaltelementen T1...T6 zweier Halbbrücken auf unterschiedlichen Potentialen liegen.

In einem Schritt 110 wird andernfalls ein Generieren von pulsweitenmodulierten Schaltsignalen für die Schaltelemente T1...T6 der Halbbrücken durchgeführt, die mindestens so weit von der Mittenzentrierung abweichen, dass eine ausreichende Mindestmessdauer $T_M$ bereitgestellt wird, wobei die Schaltsignale der Schaltelemente T1 ... T6 derart ausgebildet werden, dass zeitliche Sprünge entsprechend der Mindestmessdauer $T_M$ in den Schaltsignalen der Schaltelemente T1...T6 vermieden werden, und wobei eine 1-Shunt-Strommessung innerhalb der bereitgestellten Mindestmessdauer $T_M$ durchgeführt wird.

Fig. 14 zeigt ein prinzipielles Blockschaltbild einer Vorrichtung 200 zum Betreiben einer elektrischen Synchronmaschine. Erkennbar ist eine Generierungseinrichtung 210 zum Generieren von mittenzentrierten pulsweitenmodulierten Schaltsignalen für die Schaltelemente T1 ... T6 (nicht dargestellt) von Halbbrücken (nicht dargestellt), wobei jeweils zwei der Schaltelemente T1...T6 zu jeweils einer Halbbrücke verschaltet sind, wobei zweite Schaltelemente T4...T6 jeder Halbbrücke komplementär zu ersten Schaltelementen T1...T3 jeder Halbbrücke angesteuert werden. Die Generierungseinrichtung ist funktional mit einer Messeinrichtung 220 zum Durchführen einer 1-Shunt-Strommessung verbunden, wobei mittels der Schaltsignale der Schaltelemente T1 ... T6 eine definierte Mindestmessdauer $T_M$ bereitgestellt wird, während der zwei Schaltsignale einer Halbbrücke auf unterschiedlichen Potentialen liegen, wobei mittels der Generierungseinrichtung 210 die Schaltsignale der Schaltelemente T1 ... T6 derart ausbildbar sind, dass zeitliche Sprünge in den Schaltsignalen der Schaltelemente T1 ... T6 entsprechend der Mindestmessdauer $T_M$ vermieden werden.

Der Fachmann kann vorgehend auch nicht oder nur teilweise offenbarte Ausführungsformen der Erfindung realisieren, ohne vom Kern der Erfindung abzuweichen.

Ein zeitlicher Sprung liegt vor, wenn von einem PWM Takt zum nächsten von einer Links-Verschiebung auf eine Rechts-Verschiebung oder umgekehrt gewechselt wird. Vorzugsweise sollen sich die Schaltsignale von einem PWM-Takt zum nächsten nur geringfügig ändern und keine großen, also zeitlichen, Sprünge aufweisen. Das Verschieben der Schaltsignale erfolgt vorzugsweise abweichend von der Mittenzentrierung nach rechts oder links, um genügend Messzeit zu erhalten. Insbesondere sollte verhindert werden, von einem PWM-Takt zum nächsten von einer Links-Verschiebung auf eine Rechts-Verschiebung, oder umgekehrt, zu wechseln.

Der Spannungszeiger, der durch die drei Halbbrücken erzeugt wird, liegt innerhalb eines Sechsecks gemäß Figur 6. Beim Betrieb der elektrischen Synchronmaschine rotiert der Spannungszeiger üblicherweise. Ein Sektorwechsel bedeutet, dass der Spannungszeiger von einem der Sektoren des Sechsecks in einen anderen wechselt.

In bekannten Verfahren wird bei jedem Sektorwechsel die PWM-Verschiebung in zwei Halbbrücken geändert, eine Halbbrücke von Links-Verschiebung auf rechts, die andere Halbbrücke entgegengesetzt. Dies verursacht, insbesondere durch zeitliche Sprünge, Geräusche und wird durch die Erfindung behoben.

**Patentansprüche**

1. Verfahren zum Betreiben einer elektrischen Synchronmaschine, aufweisend die Schritte:

   - Generieren von mittenzentrierten pulsweitenmodulierten Schaltsignalen für Schaltelemente (T1...T6) von Halbbrücken, wobei jeweils zwei der Schaltelemente (T1...T6) zu jeweils einer Halbbrücke verschaltet sind, wobei zweite Schaltelemente (T4...T6) jeder Halbbrücke komplementär zu ersten Schaltelementen (T1...T3) jeder Halbbrücke angesteuert werden, sofern dadurch eine ausreichende Mindestmessdauer ($T_M$) bereitgestellt wird, während der die Schaltsignale von Schaltelementen

(T1...T6) zweier Halbbrücken auf unterschiedlichen Potentialen liegen;
- Andernfalls:
- Generieren von pulsweitenmodulierten Schaltsignalen für die Schaltelemente (T1...T6) der Halbbrücken, die mindestens so weit von der Mittenzentrierung abweichen, dass eine ausreichende Mindestmessdauer ($T_M$) bereitgestellt wird, wobei
die Schaltsignale der Schaltelemente (T1...T6) derart ausgebildet werden, dass zeitliche Sprünge entsprechend der Mindestmessdauer ($T_M$) in den Schaltsignalen der Schaltelemente (T1...T6) vermieden werden,
- Durchführen einer 1-Shunt-Strommessung innerhalb der bereitgestellten Mindestmessdauer ($T_M$),

**dadurch gekennzeichnet, dass** im Falle, dass wenigstens zwei Schaltsignale der ersten Schaltelemente (T1, T3, T5) ein definiert großes unterschiedliches Tastverhältnis aufweisen, im Falle einer Änderung von Größenverhältnissen der Schaltsignale bei einem Übergang von einem Schaltzyklus zum nächsten, die Schaltsignale derart ausgebildet werden, dass die 1-Shunt-Strommessungen jeweils bei wechselnden Flanken der Schaltsignale durchgeführt werden.

2. Verfahren nach Anspruch 1, wobei im Falle, dass bei der 1-Shunt-Strommessung an den positiven Schaltflanken zwei Schaltsignale von unterschiedlichen Schaltelementen (T1, T2, T3) ein ähnliches Tastverhältnis aufweisen, die Schaltsignale der Schaltelemente (T1, T2, T3) mit dem größeren Tastverhältnis nach links, und das Schaltsignal des Schaltelements (T1, T2, T3) mit dem kleineren Tastverhältnis nach rechts verschoben werden.

3. Verfahren nach einem der vorhergehenden Ansprüche, wobei im Falle, dass bei der 1-Shunt-Strommessung an den negativen Schaltflanken zwei Schaltsignale von unterschiedlichen Schaltelementen (T1, T2, T3) ein ähnliches Tastverhältnis aufweisen, die Schaltsignale der Schaltelemente (T1, T2, T3) mit dem größeren Tastverhältnis nach rechts, und das Schaltsignal des Schaltelements (T1, T2, T3) mit dem kleineren Tastverhältnis nach links verschoben werden.

4. Verfahren nach einem der vorhergehenden Ansprüche, wobei im Falle, dass die Schaltsignale der ersten Schaltelemente (T1, T3, T5) ein definiert ähnliches Tastverhältnis aufweisen, steigende Flanken der drei Schaltsignale der ersten Schaltelemente (T1, T3, T5), bei denen die 1-Shunt-Strommessung durchgeführt wird, in ihrer zeitlichen Abfolge relativ zueinander fest sind und derart ausgebildet werden, dass die Mindestmessdauer ($T_M$) zwischen den Schaltsignalen der ersten Schaltelemente (T1, T3, T5) bereitgestellt wird, wobei die 1-Shunt-Strommessung bei steigenden Flanken der Schaltsignale der ersten Schaltelemente (T1, T3, T5) in der ersten Hälfte der PWM-Periode durchgeführt werden.

5. Verfahren nach einem der Ansprüche 1 bis 3, wobei im Falle, dass die Schaltsignale der ersten Schaltelemente (T1, T3, T5) ein definiert ähnliches Tastverhältnis aufweisen, fallende Flanken der drei Schaltsignale der ersten Schaltelemente (T1, T3, T5), bei denen die 1-Shunt-Strommessung durchgeführt wird, in ihrer zeitlichen Abfolge relativ zueinander fest sind und derart ausgebildet werden, dass die Mindestmessdauer ($T_M$) zwischen den Schaltsignalen der ersten Schaltelemente (T1, T3, T5) bereitgestellt wird, wobei die 1-Shunt-Strommessung bei fallenden Flanken der Schaltsignale der ersten Schaltelemente (T1, T3, T5) in der zweiten Hälfte der PWM-Periode durchgeführt werden.

6. Verfahren nach Anspruch 4 oder 5, wobei die Tastverhältnisse der drei Schaltsignale der Schaltelemente (T1, T3, T5) ähnlich und der Unterschied in den Tastverhältnissen der drei Schaltsignale vorzugsweise kleiner ca. 20% bis ca. 30% ist.

7. Verfahren nach einem der vorhergehenden Ansprüche, wobei im Falle, dass wenigstens zwei Schaltsignale der ersten Schaltelemente (T1, T3, T5) ein definiert großes unterschiedliches Tastverhältnis aufweisen, der Unterschied im Tastverhältnis größer als ca. 25 % bis ca. 100% ist.

8. Verfahren nach einem der vorhergehenden Ansprüche, wobei das Verfahren für eine permanenterregte oder für eine fremderregte Synchronmaschine durchgeführt wird.

9. Vorrichtung (200) zum Betreiben einer elektrischen Synchronmaschine, aufweisend:

- eine Generierungseinrichtung (210) zum Generieren von mittenzentrierten pulsweitenmodulierten Schaltsignalen für Schaltelemente (T1...T6) von Halbbrücken, wobei jeweils zwei der Schaltelemente (T1...T6) zu jeweils einer Halbbrücke verschaltet sind, wobei zweite Schaltelemente (T4...T6) jeder Halbbrücke komplementär zu ersten Schaltelementen (T1...T3) jeder Halbbrücke angesteuert werden, sofern dadurch eine ausreichende Mindestmessdauer ($T_M$) bereitgestellt wird, während der die Schaltsignale von Schaltelementen (T1...T6) zweier Halbbrücken auf unterschiedlichen Potentialen liegen,

Andernfalls: zum Generieren von pulsweitenmodulierten Schaltsignalen für die Schaltelemente (T1...T6) der Halbbrücken, die mindestens so weit von der Mittenzentrierung abweichen, dass eine ausreichende Mindestmessdauer ($T_M$) bereitgestellt wird;

wobei mittels der Generierungseinrichtung (210) die Schaltsignale der Schaltelemente (T1...T6) derart ausbildbar sind, dass zeitliche Sprünge in den Schaltsignalen der Schaltelemente (T1...T6) entsprechend der Mindestmessdauer vermieden werden,

- eine Messeinrichtung (220) zum Durchführen einer 1-Shunt-Strommessung, wobei mittels der Schaltsignale der Schaltelemente (T1...T6) eine definierte Mindestmessdauer ($T_M$) bereitgestellt wird, während der zwei Schaltsignalsignale einer Halbbrücke auf unterschiedlichen Potentialen liegen,

**dadurch gekennzeichnet, dass**

im Falle, dass wenigstens zwei Schaltsignale der ersten Schaltelemente (T1, T3, T5) ein definiert großes unterschiedliches Tastverhältnis aufweisen, im Falle einer Änderung von Größenverhältnissen der Schaltsignale bei einem Übergang von einem Schaltzyklus zum nächsten, die Schaltsignale derart ausgebildet werden, dass die 1-Shunt-Strommessungen jeweils bei wechselnden Flanken der Schaltsignale durchgeführt werden.

10. Computerprogrammprodukt, umfassend Befehle, die bewirken, dass die Vorrichtung (100) zum Betreiben einer elektrischen Synchronmaschine (200) nach Anspruch 9 das Verfahren nach einem der Ansprüche 1- 8 ausführt.

11. Computerlesbaren Speichermedium, auf dem das Computerprogrammprodukt nach Anspruch 10 gespeichert ist.

**Claims**

1. Method for operating an electric synchronous machine, comprising the steps of:

- generating centred pulse-width-modulated switching signals for switching elements (T1...T6) of half-bridges, wherein in each case two of the switching elements (T1...T6) are connected to one half-bridge, wherein second switching elements (T4...T6) of each half-bridge are controlled in a complementary manner to first switching elements (T1...T3) of each half-bridge if a sufficient minimum measurement duration ($T_M$) is therefore provided, during which the switching signals of switching elements (T1...T6) of two half-bridges are at different potentials;

- otherwise:
- generating pulse-width-modulated switching signals for the switching elements (T1...T6) of the half-bridges which deviate at least so far from the centring that a sufficient minimum measurement duration ($T_M$) is provided, wherein

the switching signals of the switching elements (T1...T6) are formed in such a way as to avoid time jumps corresponding to the minimum measurement duration ($T_M$) in the switching signals of the switching elements (T1...T6),

- carrying out a 1-shunt current measurement within the minimum measurement duration ($T_M$) provided,

**characterized in that**, in the event that at least two switching signals of the first switching elements (T1, T3, T5) have a defined largely different duty cycle, in the event that the proportions of the switching signals change during a transition from one switching cycle to the next, the switching signals are formed in such a way that the 1-shunt current measurements are in each case carried out at alternating edges of the switching signals.

2. Method according to Claim 1, wherein, in the event that two switching signals of different switching elements (T1, T2, T3) have a similar duty cycle in the 1-shunt current measurement at the positive switching edges, the switching signals of the switching elements (T1, T2, T3) with the larger duty cycle are shifted to the left and the switching signal of the switching element (T1, T2, T3) with the smaller duty cycle is shifted to the right.

3. Method according to either of the preceding claims, wherein, in the event that two switching signals of different switching elements (T1, T2, T3) have a similar duty cycle in the 1-shunt current measurement at the negative switching edges, the switching signals of the switching elements (T1, T2, T3) with the larger duty cycle are shifted to the right and the switching signal of the switching element (T1, T2, T3) with the smaller duty cycle is shifted to the left.

4. Method according to one of the preceding claims, wherein, in the event that the switching signals of the first switching elements (T1, T3, T5) have a defined similar duty cycle, rising edges of the three switching signals of the first switching elements (T1, T3, T5), at which the 1-shunt current measurement is carried out, are fixed in their chronological sequence relative to one another and are formed in such a way that the minimum measurement duration ($T_M$) is provided between the switching signals of the first switching elements (T1, T3, T5), wherein the 1-shunt current measurement is carried out at rising edges of the switching signals of the first switching elements (T1, T3, T5) in the first half of the PWM period.

5. Method according to one of the Claims 1 to 3, wherein, in the event that the switching signals of the first switching elements (T1, T3, T5) have a defined similar duty cycle, falling edges of the three switching signals of the first switching elements (T1, T3, T5), at which the 1-shunt current measurement is carried out, are fixed in their chronological sequence relative to one another and are formed in such a way that the minimum measurement duration ($T_M$) is provided between the switching signals of the first switching elements (T1, T3, T5), wherein the 1-shunt current measurement is carried out at falling edges of the switching signals of the first switching elements (T1, T3, T5) in the second half of the PWM period.

6. Method according to Claim 4 or 5, wherein the duty cycles of the three switching signals of the switching elements (T1, T3, T5) are similar and the difference in the duty cycles of the three switching signals is preferably smaller than approximately 20% up to approximately 30%.

7. Method according to one of the preceding claims, wherein, in the event that at least two switching signals of the first switching elements (T1, T3, T5) have a defined largely different duty cycle, the difference in the duty cycle is greater than approximately 25% up to approximately 100%.

8. Method according to one of the preceding claims, wherein the method is carried out for a permanently excited or for a separately excited synchronous machine.

9. Device (200) for operating an electric synchronous machine, comprising:

- a generating unit (210) for generating centred pulse-width-modulated switching signals for switching elements (T1 ...T6) of half-bridges, wherein in each case two of the switching elements (T1 ...T6) are connected to one half-bridge, wherein second switching elements (T4...T6) of each half-bridge are controlled in a complementary manner to first switching elements (T1 ...T3) of each half-bridge if a sufficient minimum measurement duration ($T_M$) is therefore provided, during which the switching signals of switching elements (T1 ...T6) of two half-bridges are at different potentials,

- otherwise: for generating pulse-width-modulated switching signals for the switching elements (T1... T6) of the half-bridges which deviate at least so far from the centring that a sufficient minimum measurement duration ($T_M$) is provided;
wherein, by means of the generating unit (210), the switching signals of the switching elements (T1... T6) can be formed in such a way as to avoid time jumps in the switching signals of the switching elements (T1... T6) corresponding to the minimum measurement duration,
- a measuring unit (220) for carrying out a 1-shunt current measurement, wherein, by means of the switching signals of the switching elements (T1 ...T6), a defined minimum measurement duration ($T_M$) is provided during which two switching signals of a half-bridge are at different potentials,

**characterized in that**, in the event that at least two switching signals of the first switching elements (T1, T3, T5) have a defined largely different duty cycle, in the event that the proportions of the switching signals change during a transition from one switching cycle to the next, the switching signals are formed in such a way that the 1-shunt current measurements are in each case carried out at alternating edges of the switching signals.

10. Computer program product comprising commands which cause the device (100) for operating an electric synchronous machine (200) according to Claim 9 to carry out the method according to one of Claims 1-8.

11. Computer-readable storage medium on which the computer program product according to Claim 10 is stored.

**Revendications**

1. Procédé pour faire fonctionner une machine synchrone électrique, comprenant les étapes :

- génération de signaux de commutation modulés en largeur d'impulsion à centrage central pour des éléments de commutation (T1...T6) de demi-ponts, à chaque fois deux des éléments de commutation (T1... T6) étant respectivement connectés en un demi-pont, des deuxièmes éléments de commutation (T4...T6) de chaque demi-pont étant commandés de manière complémentaire aux premiers éléments de commutation (T1...T3) de chaque demi-pont, pour autant qu'une durée de mesure minimale ($T_M$) suffisante soit ainsi mise à disposition, pendant laquelle les signaux de commutation des éléments de commutation (T1...T6) de deux demi-ponts se trouvent à des potentiels différents ;
- sans quoi :
- génération de signaux de commutation modulés en largeur d'impulsion pour les éléments de commutation (T1...T6) des demi-ponts, qui s'écartent du centrage central au moins suffisamment pour qu'une durée de mesure minimale ($T_M$) suffisante soit mise à disposition,
les signaux de commutation des éléments de commutation (T1...T6) étant configurés de telle sorte que des sauts temporels correspondant à la durée de mesure minimale ($T_M$) dans les signaux de commutation des éléments de commutation (T1...T6) sont évités,
- réalisation d'une mesure de courant à 1 shunt à l'intérieur de la durée de mesure minimale ($T_M$) mise à disposition,

**caractérisé en ce que**, dans le cas où au moins deux signaux de commutation des premiers éléments de commutation (T1, T3, T5) présentent un rapport cyclique différent d'une grandeur définie, dans le cas d'une modification des rapports de grandeur des signaux de commutation lors d'une transition d'un cycle de commutation au suivant, les signaux de commutation sont configurés de telle sorte que les mesures de courant à 1 shunt sont effectuées respectivement lors des fronts changeants des signaux de commutation.

**2.** Procédé selon la revendication 1, dans lequel, dans le cas où, lors de la mesure de courant à 1 shunt sur les fronts de commutation positifs, deux signaux de commutation d'éléments de commutation (T1, T2, T3) différents présentent un rapport cyclique similaire, les signaux de commutation des éléments de commutation (T1, T2, T3) ayant le rapport cyclique le plus grand sont décalés vers la gauche, et le signal de commutation de l'élément de commutation (T1, T2, T3) ayant le rapport cyclique le plus petit vers la droite.

**3.** Procédé selon l'une des revendications précédentes, dans lequel, dans le cas où, lors de la mesure de courant à 1 shunt sur les fronts de commutation négatifs, deux signaux de commutation d'éléments de commutation (T1, T2, T3) différents présentent un rapport cyclique similaire, les signaux de commutation des éléments de commutation (T1, T2, T3) ayant le rapport cyclique le plus grand sont décalés vers la droite, et le signal de commutation de l'élément de commutation (T1, T2, T3) ayant le rapport cyclique le plus petit vers la gauche.

**4.** Procédé selon l'une des revendications précédentes, dans lequel, dans le cas où les signaux de commutation des premiers éléments de commutation (T1, T3, T5) présentent un rapport cyclique similaire défini, les fronts montants des trois signaux de commutation des premiers éléments de commutation (T1, T3, T5), lors desquels est effectuée la mesure de courant à 1 shunt, sont fixes les uns par rapport aux autres dans leur séquence chronologique et sont configurés de telle sorte que la durée de mesure minimale ($T_M$) est mise à disposition entre les signaux de commutation des premiers éléments de commutation (T1, T3, T5), la mesure de courant à 1 shunt étant effectuée lors des fronts montants des signaux de commutation des premiers éléments de commutation (T1, T3, T5) dans la première moitié de la période PWM.

**5.** Procédé selon l'une des revendications 1 à 3, dans lequel, dans le cas où les signaux de commutation des premiers éléments de commutation (T1, T3, T5) présentent un rapport cyclique similaire défini, les fronts descendants des trois signaux de commutation des premiers éléments de commutation (T1, T3, T5), lors desquels est effectuée la mesure de courant à 1 shunt, sont fixes les uns par rapport aux autres dans leur séquence chronologique et sont configurés de telle sorte que la durée de mesure minimale ($T_M$) est mise à disposition entre les signaux de commutation des premiers éléments de commutation (T1, T3, T5), la mesure de courant à 1 shunt étant effectuée lors des fronts descendants des signaux de commutation des premiers éléments de commutation (T1, T3, T5) dans la deuxième moitié de la période PWM.

**6.** Procédé selon la revendication 4 ou 5, les rapports cycliques des trois signaux de commutation des éléments de commutation (T1, T3, T5) étant similaires et la différence dans les rapports cycliques des trois signaux de commutation étant de préférence inférieure à environ 20 % jusqu'à environ 30 %.

**7.** Procédé selon l'une des revendications précédentes, dans lequel, dans le cas où au moins deux signaux de commutation des premiers éléments de commutation (T1, T3, T5) présentent un rapport cyclique différent d'une valeur définie, la différence de rapport cyclique est supérieure d'environ 25 % jusqu'à environ 100 %.

**8.** Procédé selon l'une des revendications précédentes, le procédé étant mis en oeuvre pour une machine synchrone à excitation permanente ou à excitation séparée.

**9.** Agencement (200) pour faire fonctionner une machine synchrone, comprenant :

- un dispositif de génération (210) destiné à générer des signaux de commutation modulés en largeur d'impulsion à centrage central pour des éléments de commutation (T1...T6) de demi-ponts, à chaque fois deux des éléments de commutation (T1...T6) étant respectivement connectés en un demi-pont, des deuxièmes éléments de commutation (T4...T6) de chaque demi-pont étant commandés de manière complémentaire aux premiers éléments de commutation (T1...T3) de chaque demi-pont, pour autant qu'une durée de mesure minimale ($T_M$) suffisante soit ainsi mise à disposition, pendant laquelle les signaux de commutation des éléments de commutation (T1...T6) de deux demi-ponts se trouvent à des potentiels différents,
- dans le cas contraire : destiné à générer de signaux de commutation modulés en largeur d'impulsion pour les éléments de commutation (T6) des demi-ponts, qui s'écartent du centrage central au moins suffisamment pour qu'une durée de mesure minimale ($T_M$) suffisante soit mise à disposition ;
les signaux de commutation des éléments de commutation (T1 ... T6) pouvant être configuré au moyen du dispositif de génération (210) de telle sorte que des sauts temporels dans les signaux de commutation des éléments de commutation (T1 ... T6) correspondant à la durée de mesure minimale soient évités,
- un dispositif de mesure (220) destiné à effectuer une mesure de courant à 1 shunt, une durée de mesure minimale définie ($T_M$) étant mise à disposition au moyen des signaux de commutation des éléments de commutation (T1...T6), pendant laquelle deux signaux de commutation d'un demi-pont se trouvent à des potentiels différents,

**caractérisé en ce que**, dans le cas où au moins deux signaux de commutation des premiers éléments de commutation (T1, T3, T5) présentent un rapport cyclique différent d'une grandeur définie, dans le cas d'une modification des rapports de grandeur des signaux de commutation lors d'une transition d'un cycle de commutation au suivant, les signaux de commutation sont configurés de telle sorte que les mesures de courant à 1 shunt sont effectuées respectivement lors des fronts changeants des signaux de commutation.

10. Produit de programme informatique comprenant des instructions qui amènent l'agencement (100) destiné à faire fonctionner une machine électrique synchrone (200) selon la revendication 9 à mettre en oeuvre le procédé selon l'une des revendications 1 à 8.

11. Support de stockage lisible par ordinateur, sur lequel est enregistré le produit de programme informatique selon la revendication 10.

# Fig. 1

Stand der
Technik

# Fig. 2

Stand der
Technik

# Fig. 3
**Stand der Technik**

# Fig. 4
**Stand der Technik**

# Fig. 5
## Stand der Technik

# Fig. 6
## Stand der Technik

# Fig. 7
## Stand der Technik

# Fig. 8
## Stand der Technik

# Fig. 9

# Fig. 10

# Fig. 11

# Fig. 12

# Fig. 13

100

110

# Fig. 14

210          220          200

**IN DER BESCHREIBUNG AUFGEFÜHRTE DOKUMENTE**

**In der Beschreibung aufgeführte Patentdokumente**

- DE 102015202693 A1
- DE 102011003897 A1
- DE 102205062759